(19) 

**Europäisches Patentamt**
**European Patent Office**
**Office européen des brevets**

(11) **EP 4 614 787 A1**

(12) **EUROPEAN PATENT APPLICATION**
published in accordance with Art. 153(4) EPC

(43) Date of publication:
**10.09.2025 Bulletin 2025/37**

(21) Application number: **23884046.6**

(22) Date of filing: **27.03.2023**

(51) International Patent Classification (IPC):
**H02M 1/42** (2007.01)   **H02M 1/08** (2006.01)

(52) Cooperative Patent Classification (CPC):
**H02M 1/08; H02M 1/32; H02M 1/42; H03K 17/081;**
**Y02B 70/10**

(86) International application number:
**PCT/CN2023/083963**

(87) International publication number:
**WO 2024/093101 (10.05.2024 Gazette 2024/19)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **31.10.2022 CN 202211352053**

(71) Applicant: **GD Midea Air-Conditioning Equipment**
**Co., Ltd.**
**Foshan, Guangdong 528311 (CN)**

(72) Inventors:
• **HUO, Zhaojing**
**Foshan, Guangdong 528311 (CN)**

• **XU, Jinqing**
**Foshan, Guangdong 528311 (CN)**
• **ZHANG, Jianbin**
**Foshan, Guangdong 528311 (CN)**
• **CEN, Chang'an**
**Foshan, Guangdong 528311 (CN)**
• **LI, Ming**
**Foshan, Guangdong 528311 (CN)**

(74) Representative: **Ran, Handong et al**
**Maucher Jenkins**
**Seventh Floor Offices**
**Artillery House**
**11-19 Artillery Row**
**London SW1P 1RT (GB)**

(54) **BUCK-BOOST POWER SUPPLY SYSTEM AND AIR CONDITIONER**

(57)    Disclosed in the present disclosure are a buck-boost power supply system and an air conditioner. The buck-boost power supply system (10) comprises: a PFC circuit (120), a switch circuit (110), and an overvoltage protection circuit (140). The switch circuit (110) regulates the voltage output by the PFC circuit (120) to a load (20), and the overvoltage protection circuit (140) charges parasitic capacitance in the switch circuit (110) when the switch circuit (110) is abnormally turned off, so as to reduce the voltage of each switch transistor in the switch circuit (110) after the switch circuit (110) is turned on. In this way, the technical problem of breakdown of the buck-boost power supply system due to high voltage when the buck-boost power supply system is suddenly cut off is solved.

FIG. 1

**Description**

**CROSS-REFERENCE TO RELATED APPLICATION**

This application claims priority to the Chinese patent application No. 202211352053.0, filed on October 31, 2022, and entitled "Buck-Boost Power Supply System and Air Conditioner", the entire contents of which are incorporated herein by reference.

**TECHNICAL FIELD**

The invention belongs to the technical field of power supply control and relates to a buck-boost power supply system and an air conditioner.

**BACKGROUND**

In a condition that a power of an air conditioner is low, a compressor basically runs in a relatively low frequency range. At this time, a load demand voltage is significantly lower than a bus voltage. A buck-boost power supply system may control and decrease the bus voltage, thereby reducing circuit losses. However, when the buck-boost power supply system is suddenly powered off, the buck-boost power supply system is subjected to a high voltage and is broken down due to a characteristic of inductive constant current inside the buck-boost power supply system.

**SUMMARY**

A buck-boost power supply system and an air conditioner are provided according to an embodiment of the invention, a problem of breakdown of a buck-boost power supply system due to high voltage when the buck-boost power supply system is suddenly powered off is solved by utilizing one or more embodiments of the invention.

According to a first aspect of the invention, a buck-boost power supply system is provided, including: a PFC circuit, wherein a first input terminal of the PFC circuit is configured as a mains-electricity neutral terminal; a switching circuit, wherein a first terminal of the switching circuit is configured as a mains-electricity live terminal, a second terminal of the switching circuit being connected to a second input terminal of the PFC circuit, and wherein the switching circuit is configured to adjust a voltage output by the PFC circuit to a load; and an overvoltage protection circuit connected to the switching circuit and configured to charge a parasitic capacitance in the switching circuit when the switching circuit is abnormally turned off, to reduce voltages of various switch tubes in the switching circuit after the switching circuit is turned on.

According to a second aspect of the invention, an air conditioner is provided, including the buck-boost power supply system according to any one of the embodiments of the first aspect.

**BRIEF DESCRIPTION OF DRAWINGS**

In order to more clearly illustrate the technical solutions in the embodiments of the invention, the following briefly introduces the accompanying drawings required for describing the embodiments. Obviously, the accompanying drawings in the following description only illustrate some embodiments of the invention, and for those skilled in the art, other accompanying drawings can also be obtained based on these accompanying drawings without creative efforts.

FIG. 1 is a schematic structural diagram of a buck-boost power supply system according to some embodiments of the invention.

FIG. 2 is a flow chart of a buck-boost control method of the buck-boost power supply system according to some embodiments of the invention.

FIG. 3 shows a first circuit diagram of the buck-boost power supply system in FIG. 1.

FIG. 4 shows a schematic structural diagram of a PFC circuit in FIG. 1.

FIG. 5 shows a schematic structural diagram of an overvoltage protection circuit in FIG. 1.

FIG. 6 shows a second circuit diagram of the buck-boost power supply system in FIG. 1.

In the accompanying drawings, corresponding relationships between reference signs and component names are as follows:

| Reference signs | Component names | Reference signs | Component names |
|---|---|---|---|
| 110 | switching circuit | DZ1~DZ3 | first Zener diode to third Zener diode |
| 120 | PFC circuit | D1~D3 | first diode to third diode |
| 130 | controller | Q1~Q7 | first switch tube to seventh switch tube |
| 140 | overvoltage protection circuit | C1 | first capacitor element |
| 10 | buck-boost power supply system | L1~L2 | first inductor element to second inductor element |
| 20 | load | VCC | operating voltage |
| 1411 | first switch unit | 121 | totem-pole PFC circuit |
| 1421 | second switch unit | 122 | ordinary PFC circuit |
| 1412 | common unit | L | mains-electricity live terminal |
| 141 | first charging branch | N | mains-electricity neutral terminal |
| 142 | second charging branch | | |

## DETAILED DESCRIPTION

The technical solutions in the embodiments of the invention will be clearly and completely described below with reference to the accompanying drawings in the embodiments of the invention. Obviously, the described embodiments are only some embodiments, rather than all embodiments of the invention. Based on the embodiments in the invention, all other embodiments obtained by those skilled in the art without creative efforts fall within the protection scope sought by the invention.

It should be noted that all directional indications in the embodiments of the invention are only configured to explain the relative position relationship, movement status and so on among the components in a specific posture. If the specific posture changes, the directional indication will also change accordingly.

In the invention, unless otherwise clearly specified and defined, the terms "connected", "fixed" and so on should be understood in a broad sense. For example, "fixed" can be a fixed connection, a detachable connection, or an integral connection; it can be a mechanical connection or an electrical connection; it can be a direct connection or an indirect connection through an intermediate medium; it can be an internal connection of two elements or an interaction relationship between two elements, unless otherwise clearly defined. For those skilled in the art, the specific meanings of the above terms in the embodiments of the invention can be understood according to specific circumstances.

Descriptions such as "first", "second" and so on in the invention are only used for descriptive purposes and cannot be understood as indicating or implying relative importance thereof or implicitly indicating the number of the indicated technical features. Therefore, the features defined as "first" or "second" may explicitly or implicitly include at least one features. The technical solutions in various embodiments can be combined with one another, but the combined technical solutions must be based on that they can be implemented by those skilled in the art. When the combined technical solutions are contradictory or cannot be realized, it should be considered that such combined technical solutions do not exist, and are not within the protection scope sought for by the invention.

In order to achieve an effect of circuit overvoltage protection, a buck-boost power supply system 10 is provided according to an embodiment of the invention, which is applied to an electrical apparatus. The electrical apparatus may be an air conditioner, a refrigerator, and the like.

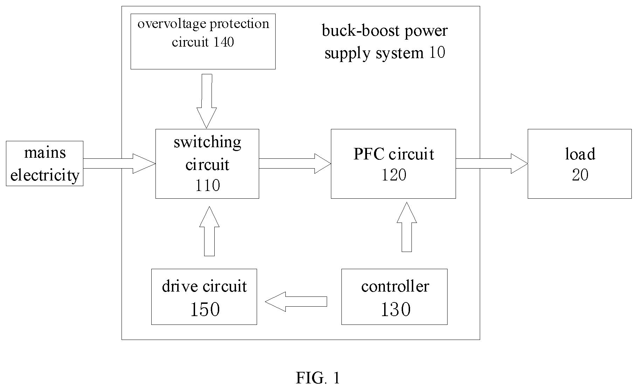

As shown in FIG. 1, a buck-boost power supply system 10 is provided according to an embodiment of the disclosure, which may include: a switching circuit 110, a power factor correction (PFC) circuit 120 and an overvoltage protection circuit 140, A first input terminal of the PFC circuit 120 is configured as a mains-electricity neutral terminal N. As for the switching circuit 110, a first terminal of the switching circuit 110 is configured as a mains-electricity live terminal L, and a second terminal of the switching circuit 110 is connected to a second input terminal of the PFC circuit 120. The switching circuit 110 may be configured to adjust a voltage output by the PFC circuit 120 to a load 20. The overvoltage protection circuit 140 is connected to the switching circuit 110, and can be configured to charge a parasitic capacitance in the switching circuit 110 when the switching circuit 110 is abnormally turned off, to reduce voltages of various switch tubes in the switching circuit 110 after the switching circuit 110 is turned on.

Since the overvoltage protection circuit 140 is provided in the switching circuit 110 of the buck-boost power supply system 10, in a condition that the switching circuit 110 is abnormally turned off, the overvoltage protection circuit 140 charges the parasitic capacitance in the switching circuit 110 to turn on the switching circuit 110, so as to reduce voltages of various switch tubes in the switching circuit 110. Thus the switching circuit 110 will not be subjected to excessively high voltage, and thus a breakdown of various switch tubes due to the excessively high voltage can be avoided. A damage to the buck-boost power supply system 10 can be further avoided. Therefore, the effect of overvoltage protection for the buck-boost power supply system 10 can be achieved.

It is understandable that the buck-boost power supply system 10 may further include a drive circuit 150 connected to the switching circuit 110. In a condition that the drive circuit 150 is powered off, the switching circuit 110 is abnormally turned off.

The buck-boost power supply system 10 may further include a controller 130 connected to an input terminal of the drive circuit 150. The controller 130 may be configured to: in a condition that an input terminal of the switching circuit 110 is connected to a mains electricity, if it is detected that a load 20 currently connected to the PFC circuit 120 is in a light load state, obtain a target voltage required to control the load 20 and a current bus voltage output by the PFC circuit 120, and control the drive circuit 150 to output a drive signal according to a magnitude relationship between the current bus voltage and the target voltage. The drive signal is used to drive a turn-on of the switching circuit 110 and adjust a turn-on delay time of the switching circuit 110, to reduce a difference between the bus voltage output by the PFC circuit 120 and the target voltage.

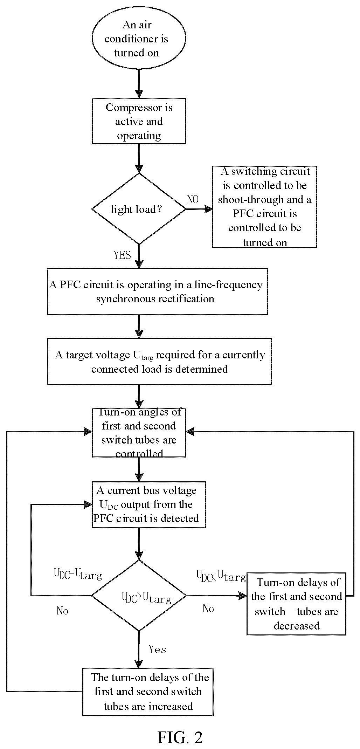

As shown in FIGs. 1 and 2, it can be understood that, according to the magnitude relationship between the current bus voltage and the target voltage, a process of adjusting the turn-on delay time of the switching circuit 110 may include: increasing, if the current bus voltage is higher than the target voltage, the turn-on delay time of the switching circuit 110 to reduce the bus voltage output by the PFC circuit 120; reducing, if the current bus voltage is lower than the target voltage, the turn-on delay time of the switching circuit 110 to increase the bus voltage output by the PFC circuit 120; and maintaining, if the current bus voltage is equal to the target voltage, the turn-on delay time of the switching circuit 110 unchanged. Thus, an output bus voltage across a first capacitor element in the PFC circuit 120 matches the target voltage required by the load 20. Under the light load state, a voltage provided by the PFC circuit 120 to the load 20 is adapted to the target voltage required by the load 20 by continuously adjusting the bus voltage output by the PFC circuit 120, to avoid a voltage provided by the buck-boost power supply system 10 to the load 20 significantly exceeding the target voltage required by the load 20, and further avoid unnecessary circuit losses. Once the switching circuit 110 is abnormally turned off, the switching circuit 110 will be damaged and unable to continue working, and thus a normal operation of the PFC circuit 120 is affected.

A load including a compressor of the air conditioner is taken as an example. Under the light load state, the bus voltage being reduced can save energy because there are a large number of switch modules, such as an inverter module of the compressor, in the controller 130 of the air conditioner. Each switching action of the switch modules will generate a switching loss, and the switching loss is divided into a turn-on loss and a turn-off loss, that is, $P_{loss} = P_{tron} + P_{tfoff}$.

A single turn-on loss is: $P_{tron} = \int_0^{t_r} U_{DC}(t) I_{ds}(t) \ dt = \frac{1}{6} U_{DC} I_{D1} t_r$ , where $U_{DC}$ is a bus voltage; $I_{D1}$ is a current passing through a switch tube at a moment when a switch module is turned on; and tf is a time for the current to rise from 10% to 90% when the switch tube is turned on.

A single turn-off loss is: $P_{tfoff} = \int_0^{t_f} U_{DC}(t) I_{ds}(t) \ dt = \frac{1}{6} U_{DC} I_{D2} t_f$ , where $U_{DC}$ is a bus voltage; $I_{D2}$ is a current passing through a switch tube at a moment a switch module is turned off; and $t_f$ is a time for the current to drop from 90% to 10% when the switch tube is turned off.

It can be seen from the above two formulas that when the currently connected load 20 is in the light load state, the turn-on loss and the turn-off loss can be reduced by reducing the bus voltage, to reduce the circuit loss.

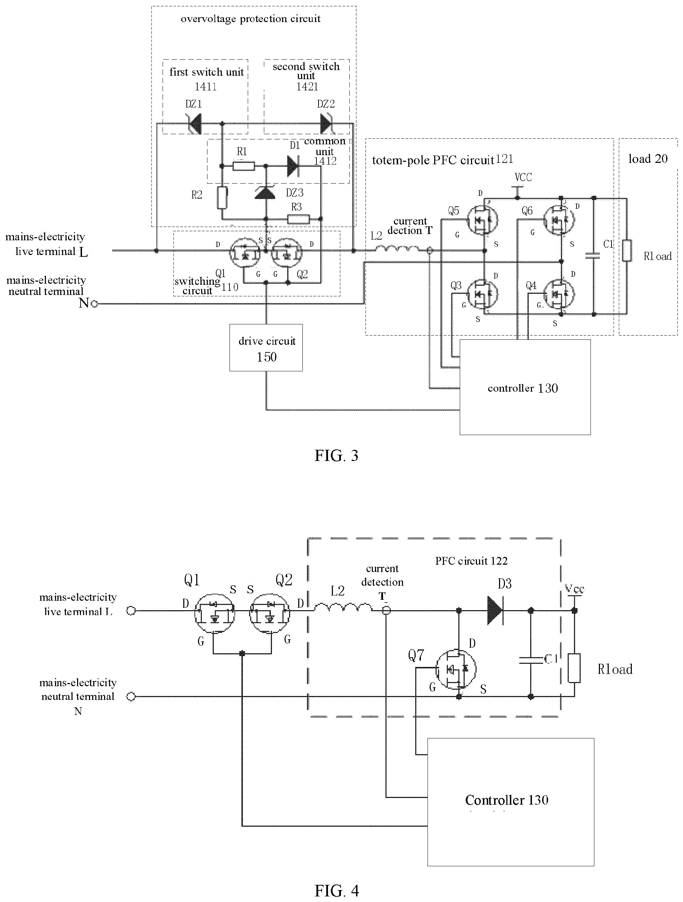

It is understandable that the switching circuit 110 may have a variety of circuit implementations. As shown in FIG. 3, the switching circuit 110 may include a first switch tube Q1 and a second switch tube Q2. Optionally, a source of the first switch tube Q1 is connected to a source of the second switch tube Q2. A drain of the first switch tube Q1 is connected to the mains-electricity live terminal L and a first terminal of the overvoltage protection circuit 140. A drain of the second switch tube Q2 is respectively connected to a second input terminal of the PFC circuit 120 and a fourth terminal of the overvoltage protection circuit 140. A gate of the first switch tube Q1 is respectively connected to a gate of the second switch tube Q2, a third terminal of the overvoltage protection circuit 140, and an output terminal of the drive circuit 150, An input terminal of the drive circuit 150 is connected to the controller 130, and thus the controller 130 can provide a control signal to the drive circuit 150, to control the drive circuit 150 to provide a drive signal for driving the second switch tube Q2 and the first switch tube Q1.

The PFC circuit 120 may be a totem-pole PFC circuit 121. As shown in FIG. 3, the totem-pole PFC circuit 121 may include: a second inductor element L2, a third switch tube Q3, a fourth switch tube Q4, a fifth switch tube Q5, a sixth switch tube Q6, and a first capacitor element C1. Optionally, a first terminal of the second inductor element L2 is connected to an output terminal of the switching circuit 110. A second terminal of the second inductor element L2 is connected to a source of the fifth switch tube Q5 and a drain of the third switch tube Q3. A gate of the third switch tube Q3 is connected to the controller 130. A source of the third switch tube Q3 is respectively connected to a source of the fourth switch tube Q4 and a terminal of the first capacitor element C1. A gate of the fourth switch tube Q4 is connected to the controller 130. A drain of the fourth switch tube Q4 is connected to a source of the sixth switch tube Q6 and the mains-electricity neutral terminal N. A drain of the fifth switch tube Q5 is respectively connected to a drain of the sixth switch tube Q6 and another terminal of the first capacitor element C1. At the same time, the drain of the fifth switch tube Q5 and a drain of the sixth switch tube Q6 each are also connected to an operating voltage VCC. A gate of the fifth switch tube Q5 is connected to the controller 130. A gate of the sixth switch tube Q6 is connected to the controller 130. Thus, the controller 130 can control a turn-on and turn-off of the third switch tube Q3, the fourth switch tube Q4, the fifth switch tube Q5 and the sixth switch tube Q6 in the totem-pole PFC circuit 121.

It should be noted that, on the basis of the switching circuit 110 including the first switch tube Q1 and the second switch tube Q2, the output terminal of the switching circuit 110 is the drain of the second switch tube Q2, that is, the first terminal of the second inductor element L2 is connected to the drain of the second switch tube Q2.

As shown in FIG. 4, it is different from the totem-pole PFC circuit 121 shown in FIG. 3 that the PFC circuit 120 may be an ordinary PFC circuit 122, which, in addition to the first capacitor element C1 and the second inductor element L2 that are the same as those in the totem-pole PFC circuit 121, further includes portions: a seventh switch tube Q7 and a third diode D3 that are different from the totem-pole PFC circuit 121. Optionally, the first terminal of the second inductor element L2 is connected to the output terminal of the switching circuit 110. The second terminal of the second inductor element L2 is connected to a drain of the seventh switch tube Q7 and is connected to an anode of the third diode D3. A terminal of the first capacitor element C1 is connected to a source of the seventh switch tube Q7 and is connected to the mains-electricity neutral terminal N. A cathode of the third diode D3 is connected to another terminal of the first capacitor element C1 and is connected to a positive electrode of a power supply. A gate of the seventh switch tube Q7 is connected to the controller 130, and thus the controller 130 can control a turn-on and turn-off of the seventh switch tube Q7.

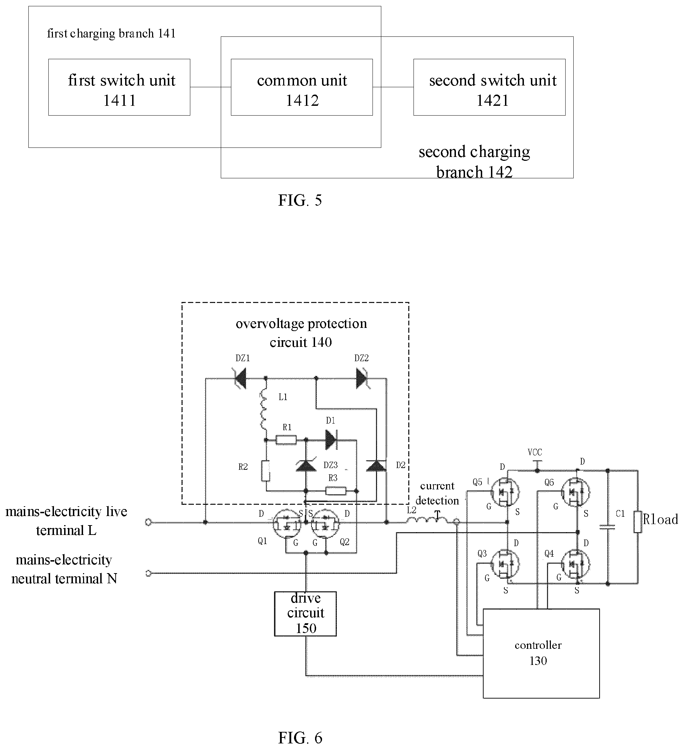

As shown in FIGs. 3 and 5, it should be noted that the overvoltage protection circuit 140 may include a first charging branch 141 and a second charging branch 142. A terminal of the first charging branch 141 is connected to the mains-electricity live terminal L, and another terminal of the first charging branch 141 is connected to the gate of the first switch tube Q1 and the gate of the second switch tube Q2. Optionally, the first charging branch 141 is configured to charge a parasitic capacitance in the first switch tube Q1 and a parasitic capacitance in the second switch tube Q2 when the switching circuit 110 is abnormally turned off; a terminal of the second charging branch 142 is connected to the second input terminal of the PFC circuit 120, and another terminal of the second charging branch 142 is respectively connected to the gate of the first switch tube Q1 and the gate of the second switch tube Q2. Optionally, the second charging branch 142 is configured to charge the parasitic capacitance in the first switch tube Q1 and the parasitic capacitance in the second switch tube Q2 when the switching circuit 110 is abnormally turned off.

When the first switch tube Q1 and the second switch tube Q2 are abnormally turned off, a current flowing into the second inductor element L2 charges the parasitic capacitance in the first switch tube Q1 and the parasitic capacitance in the second switch tube Q2 through the first charging branch 141 and the second charging branch 142. After voltages of the sources and gates of the first switch tube Q1 and the second switch tube Q2 are higher than the turn-on voltage, the first switch tube Q1 and the second switch tube Q2 will be turned on, and thus the first charging branch 141 and the second charging branch 142 can turn on the switching circuit 110 in a condition that the switching circuit 110 are subjected to an over-high voltage, to reduce a voltage across the switching circuit 110 and avoid the switching circuit 110 being broken down due to the high voltage thereof.

As shown in FIGs. 3 and 5, the first charging branch 141 may include a first switch unit 1411 and a common unit 1412. A terminal of the first switch unit 1411 is connected to the mains-electricity live terminal L. An input terminal of the common unit 1412 is connected to another terminal of the first switch unit 1411. The second charging branch 142 includes a second switch unit 1421 and the common unit 1412. A terminal of the second switch unit 1421 is connected to a second input terminal of a PFC circuit (such as the totem-pole PFC circuit 121). The input terminal of the common unit 1412 is connected to another terminal of the second switch unit 1421. An output terminal of the common unit 1412 is connected to the gate of the first switch tube Q1 and the gate of the second switch tube Q2.

It should be noted that the first switch unit 1411 may include a first Zener diode DZ1. The second switch unit 1421 may include a second Zener diode DZ2. A cathode of the first Zener diode DZ1 is connected to the mains-electricity live terminal L. A cathode of the second Zener diode DZ2 is connected to the second input terminal of the PFC circuit (such as the totem-pole PFC circuit 121). An anode of the first Zener diode DZ1 is connected to an anode of the second Zener diode DZ2. In some embodiments, the common unit 1412 may include a first resistor R1 and a first diode D1. A first terminal of the first resistor R1 is respectively connected to the anode of the first Zener diode DZ1 and the anode of the second Zener diode DZ2. An anode of the first diode D1 is connected to a second terminal of the first resistor R1. A cathode of the first diode D1 is connected to the gate of the first switch tube Q1 and the gate of the second switch tube Q2.

When the switching circuit 110 is abnormally turned off, the voltage across the switching circuit 110 will rise rapidly and reach a breakdown voltage of the first Zener diode DZ1. After the first Zener diode DZ1 is broken down, a current will flow from the first Zener diode DZ1 through the first resistor R1, the first diode D1, the first switch tube Q1 and the second switch tube Q2 in sequence to charge the first switch tube Q1 and the second switch tube Q2.

Similarly, when the switching circuit 110 is abnormally turned off, the voltage across the switching circuit 110 will rise rapidly and reach a breakdown voltage of the second Zener diode DZ2. After the second Zener diode DZ2 is broken down, a current flows from the second Zener diode DZ2 through the first resistor R1, the first diode D1, the first switch tube Q1 and the second switch tube Q2 in sequence to charge the first switch tube Q1 and the second switch tube Q2.

It can be understood that the switching circuit 110 being abnormally turned off indicates that: in a condition that the drive circuit 150 connected to the switching circuit 110 is powered off, the drive circuit 150 cannot provide a turn-on voltage to the first switch tube Q1 and the second switch tube Q2, to cause the first switch tube Q1 and the second switch tube Q2 to be turned off.

As shown in FIG. 3, the overvoltage protection circuit 140 may further include: a third Zener diode DZ3. An anode of the third Zener diode DZ3 is connected to the source of the first switch tube Q1 and the source of the second switch tube Q2, respectively. A cathode of the third Zener diode DZ3 is connected to the second terminal of the first resistor R1. The first resistor R1 and the third Zener diode DZ3 form a voltage stabilizing circuit to protect the gates of the first switch tube Q1 and the second switch tube Q2 from being damaged by overvoltage.

As shown in FIG. 3, the overvoltage protection circuit 140 may also include a second resistor R2. A first terminal of the second resistor R2 is respectively connected to the first terminal of the first resistor R1. A second terminal of the second resistor R2 is connected to the source of the first switch tube Q1, the source of the second switch tube Q2, and the third Zener diode DZ3. The second resistor R2 acts as a current limiting resistor when the first Zener diode DZ1 and the second Zener diode DZ2 are in an overvoltage state. The second resistor R2 can also provide a discharge circuit for a leakage current in a condition that the switching circuit 110 is in an off-state, to avoid the first switch tube Q1 and the second switch tube Q2 from being turned on by accident.

As shown in FIG. 3, the overvoltage protection circuit 140 may also include a third resistor R3. A first terminal of the third resistor R3 is respectively connected to the second terminal of the second resistor R2, the source of the first switch tube Q1, the source of the second switch tube Q2, and the third Zener diode DZ3. A second terminal of the third resistor R3 is respectively connected to the gate of the first switch tube Q1 and the gate of the second switch tube Q2. The third resistor R3 provides a discharge circuit for electric charges for charging in a condition that the first switch tube Q1 and the second switch tube Q2 are turned on.

It should be noted that under an action of the overvoltage protection circuit 140, after the switching circuit 110 is turned on, a driving source is again disappeared for turning on the gates of the first switch tube Q1 and the second switch tube Q2, because the first switch tube Q1 and the second switch tube Q2 are voltage-driven devices, and the gates and sources of the first switch tube Q1 and the second switch tube Q2 have characteristics of high impedance and ultra-low leakage current, so the electric charges for charging of the first switch tube Q1 and the second switch tube Q2 when they are turned on, can only be discharged through the third resistor R3. The first diode D1, the first Zener diode DZ1, the second Zener diode DZ2, and the first resistor R1 only provide a charging circuit and do not have a function of providing a discharge circuit. Therefore, the turn-on delay time t of the switching circuit 110 after an overvoltage turn-on can be adjusted by adjusting a resistance value of the third resistor R3, and the calculation method for the turn-on delay time t is:

$$t = RC \ln(\frac{V_1}{V_1 - V_t})$$ , where $V_1$ is a voltage across the gate and source of the first switch tube Q1 and the second switch tube Q2 at a turn-on time, $V_t$ is a turn-off threshold voltage of the first switch tube Q1 and the second switch tube Q2, R is the resistance value of the third resistor R3, and C is a capacitance of the first capacitor element C1.

The overvoltage protection circuit 140, as shown in FIG. 6 and different from the above overvoltage protection circuit 140, may further include a first inductor element L1 and a second diode D2. Optionally, a first terminal of the first inductor element L1 is respectively connected to the anode of the first Zener diode DZ1, the anode of the second Zener diode DZ2, and a cathode of the second diode D2. A second terminal of the first inductor element L1 is respectively connected to the first terminal of the first resistor R1 and the first terminal of the second resistor R2. An anode of the second diode D2 is respectively connected to the second terminal of the second resistor R2, the first terminal of the third resistor R3, the anode of the third Zener diode DZ3, the source of the first switch tube Q1, and the source of the second switch tube Q2.

The first inductor element L1 stores energy when the first Zener diode DZ1 and the second Zener diode DZ2 are turned on due to overvoltage, and provides, after the switching circuit 110 is turned on, a charging current for the parasitic capacitance in the first switch tube Q1 and the parasitic capacitance in the second switch tube Q2 for maintaining a turn-on state of the switching circuit 110. Therefore, the overvoltage protection circuit 140 with the first inductor element L1 can provide the switching circuit 110 with a higher turn-on voltage and a longer turn-on delay time. Optionally, the charging current flows from the first inductor L1 through the first resistor R1, the first diode D1, the first switch tube Q1, the second switch tube Q2, the second diode D2, and the first inductor L1 in sequence.

It should be noted that, in the embodiments of the invention, various switch tubes Q1 to Q6 each may be a parallel structure of a MOS and a diode.

Based on the same concept, an air conditioner is provided according to an embodiment of the invention, including a buck-boost power supply system. A structure of the buck-boost power supply system and the overvoltage protection circuit can be referred to descriptions in the aforementioned embodiments and will not be repeated here. The air conditioner using the aforementioned buck-boost power supply system and its overvoltage protection circuit can protect a circuit from overvoltage damage when an internal circuit of the buck-boost power supply system is subjected to a high voltage.

One or more technical solutions provided by the embodiments of the invention achieve at least the following technical effects or advantages: since the overvoltage protection circuit is provided in the switching circuit of the buck-boost power supply system, in a condition that the switching circuit is abnormally turned off, the overvoltage protection circuit charges the parasitic capacitance in the switching circuit to turn on the switching circuit, to reduce voltages of various switch tubes in the switching circuit. Thus, the switching circuit will not be subjected to excessively high voltage, and thus a breakdown of various switch tubes due to the excessively high voltage can be avoided. Damage to the buck-boost power supply system can be further avoided. Therefore, the effect of overvoltage protection for the buck-boost power supply system can be achieved.

The above descriptions are merely embodiments of the application and are not intended to limit the application. For those skilled in the art, the application may have various modifications and changes. Any modifications, equivalent substitutions, improvements, etc. made within the spirit and principles of this application should be included within a scope sought by the claims of this application.

## Claims

1. A buck-boost power supply system, comprising:

   a PFC circuit, a first input terminal of which is configured as a mains-electricity neutral terminal;
   a switching circuit, a first terminal of which is configured as a mains-electricity live terminal, and a second terminal of which is connected to a second input terminal of the PFC circuit, wherein the switching circuit is configured to adjust a voltage output by the PFC circuit to a load; and
   an overvoltage protection circuit, connected to the switching circuit and configured to charge a parasitic capacitance in the switching circuit when the switching circuit is abnormally turned off, to reduce voltages of various switch tubes in the switching circuit after the switching circuit is turned on.

2. The buck-boost power supply system according to claim 1, further comprising: a drive circuit connected to the switching circuit, wherein when the drive circuit is powered off, the switching circuit is abnormally turned off.

3. The buck-boost power supply system according to claim 1, wherein:

   the switching circuit comprises a first switch tube and a second switch tube whose gates are connected to one another, and
   the overvoltage protection circuit comprises:

   a first charging branch, a terminal of which is connected to the mains-electricity live terminal, and another terminal of which is connected to the gates of the first switch tube and the second switch tube, the first charging branch being configured to charge parasitic capacitances in the first switch tube and the second switch tube when the switching circuit is abnormally turned off; and
   a second charging branch, a terminal of which is connected to the second input terminal of the PFC circuit, and another terminal of which is connected to the gates of the first switch tube and the second switch tube, the second charging branch being configured to charge the parasitic capacitances in the first switch tube and the second switch tube when the switching circuit is abnormally turned off.

4. The buck-boost power supply system according to claim 3, wherein:

   the first charging branch comprises a first switch unit and a common unit, a terminal of the first switch unit being connected to the mains-electricity live terminal, an input terminal of the common unit being connected to another terminal of the first switch unit;

the second charging branch comprises a second switch unit and the common unit, a terminal of the second switch unit being connected to the second input terminal of the PFC circuit, the input terminal of the common unit being connected to another terminal of the second switch unit; and

an output terminal of the common unit is connected to the gate of the first switch tube and the gate of the second switch tube.

5. The buck-boost power supply system according to claim 4, wherein:

the first switch unit comprises a first Zener diode, a cathode of the first Zener diode being connected to the mains-electricity live terminal; and

the second switch unit comprises a second Zener diode, a cathode of the second Zener diode being connected to the second input terminal of the PFC circuit, an anode of the first Zener diode being connected to an anode of the second Zener diode.

6. The buck-boost power supply system according to claim 5, wherein the common unit comprises:

a first resistor, a first terminal of which is connected to the anode of the first Zener diode; and

a first diode, an anode of which is connected to a second terminal of the first resistor, and a cathode of which is connected to the gate of the first switch tube and the gate of the second switch tube.

7. The buck-boost power supply system according to claim 6, wherein the common unit further comprises:

a first inductor element, a first terminal of which is connected to the anode of the first Zener diode, and a second terminal of which is connected to the first terminal of the first resistor; and

a second diode, an anode of which is connected to a source of the first switch tube and a source of the second switch tube, and a cathode of which is connected to the first terminal of the first inductor element, wherein the first inductor element is configured to store energy when the first Zener diode and the second Zener diode are turned on due to overvoltage, and provide, after the switching circuit is turned on, a charging current for the parasitic capacitances in the first switch tube and the second switch tube for maintaining a turn-on state of the switching circuit.

8. The buck-boost power supply system according to claim 6 or 7, wherein:

the overvoltage protection circuit further comprises a third Zener diode; and

an anode of the third Zener diode is connected to the source of the first switch tube and the source of the second switch tube, and a cathode of the third Zener diode is connected to the second terminal of the first resistor.

9. The buck-boost power supply system according to claim 8, wherein the overvoltage protection circuit further comprises a second resistor, a first terminal of the second resistor being connected to the first terminal of the first resistor, the anode of the first Zener diode, and the anode of the second Zener diode, a second terminal of the second resistor being connected to the source of the first switch tube and the source of the second switch tube.

10. The buck-boost power supply system according to claim 8, wherein the overvoltage protection circuit further comprises:

a third resistor, a first terminal of which is connected to the source of the first switch tube and the source of the second switch tube, and a second terminal of which is connected to the gate of the first switch tube and the gate of the second switch tube.

11. An air conditioner, comprising the buck-boost power supply system according to any one of claims 1 to 10.

FIG. 1

FIG. 2

FIG. 3

FIG. 4

first charging branch 141

| first switch unit 1411 | common unit 1412 | second switch unit 1421 |

second charging branch 142

FIG. 5

overvoltage protection circuit 140

DZ1          DZ2

L1

R1     D1

R2        DZ3     D2
         R3

mains-electricity live terminal L

mains-electricity neutral terminal N

D   S  S   D

Q1   G   G   Q2

current detection L2

VCC

Q5   D        D   Q6

G    S        S   G

C1    Rload

Q3   D        D   Q4

G    S        S   G

drive circuit 150

controller 130

FIG. 6

## INTERNATIONAL SEARCH REPORT

| International application No. |
|---|
| **PCT/CN2023/083963** |

| A. | CLASSIFICATION OF SUBJECT MATTER |
|---|---|

H02M 1/42(2007.01)i;  H02M 1/08(2006.01)i

According to International Patent Classification (IPC) or to both national classification and IPC

| B. | FIELDS SEARCHED |
|---|---|

Minimum documentation searched (classification system followed by classification symbols)

IPC: H02M

Documentation searched other than minimum documentation to the extent that such documents are included in the fields searched

Electronic data base consulted during the international search (name of data base and, where practicable, search terms used)

CNTXT, ENTXT, ENTXTC, DWPI, WPABS, CNKI, IEEE: 双向, 交流, 过压, 过电压, 感性, 电感, 断, 停, 功率因数, 功率因素, 功因, 开关, PFC, power factor, induct+, bi direction+, AC, over volt+, off, switch+

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | CN 112054665 A (VALEO SIEMENS EAUTOMOTIVE FRANCE SAS) 08 December 2020 (2020-12-08) <br> description, paragraphs 2-10, and figures 1-2 | 1-6, 11 |
| Y | JP 2011187833 A (TOYOTA MOTOR CORP.) 22 September 2011 (2011-09-22) <br> description, paragraphs 13-62, and figures 1-7 | 1-6, 11 |
| A | KR 20210015321 A (LG ELECTRONICS INC.) 10 February 2021 (2021-02-10) <br> entire document | 1-11 |
| A | US 2021305980 A1 (LS ELECTRIC CO., LTD. et al.) 30 September 2021 (2021-09-30) <br> entire document | 1-11 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **06 June 2023** | **30 June 2023** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

| INTERNATIONAL SEARCH REPORT<br>Information on patent family members | | International application No.<br>**PCT/CN2023/083963** |

| Patent document<br>cited in search report | | | Publication date<br>(day/month/year) | Patent family member(s) | | | Publication date<br>(day/month/year) |
|---|---|---|---|---|---|---|---|
| CN | 112054665 | A | 08 December 2020 | FR | 3097089 | A1 | 11 December 2020 |
| | | | | FR | 3097089 | B1 | 25 March 2022 |
| | | | | US | 2020389086 | A1 | 10 December 2020 |
| | | | | US | 11264894 | B2 | 01 March 2022 |
| | | | | EP | 3748831 | A1 | 09 December 2020 |
| JP | 2011187833 | A | 22 September 2011 | None | | | |
| KR | 20210015321 | A | 10 February 2021 | KR | 102266356 | B1 | 18 June 2021 |
| US | 2021305980 | A1 | 30 September 2021 | US | 11482997 | B2 | 25 October 2022 |
| | | | | KR | 20200024069 | A | 06 March 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211352053